# EUROPÄISCHE PATENTSCHRIFT

(11) **EP 3 078 055 B1**
(45) Veröffentlichungstag und Bekanntmachung des Hinweises auf die Patenterteilung: **14.10.2020**
(21) Anmeldenummer: 14806294.6
(22) Anmeldetag: 04.12.2014
(51) Int. Cl.: H01L 21/304, H01L 21/02, H01L 31/18

(54) **VERFAHREN ZUM ERZEUGEN GROSSFLÄCHIGER FESTKÖRPERSCHICHTEN**
METHOD FOR PRODUCING LARGE-AREA SOLID-BODY LAYERS
PROCÉDÉ PERMETTANT DE PRODUIRE DES COUCHES DE SOLIDE DE GRANDE SURFACE

(30) Priorität: 04.12.2013 DE 102013020693
(43) Veröffentlichungstag der Anmeldung: 12.10.2016
(73) Patentinhaber: Siltectra GmbH, 01099 Dresden (DE)
(72) Erfinder: LICHTENSTEIGER, Lukas, CH-8037 Zürich (CH); RICHTER, Jan, 01277 Dresden (DE); DRESCHER, Wolfram, 01099 Dresden (DE)
(74) Vertreter: Westphal, Mussgnug & Partner Patentanwälte mbB
(86) Internationale Anmeldenummer: PCT/EP2014/076496
(87) Internationale Veröffentlichungsnummer: WO 2015/082582

(56) Entgegenhaltungen:
- WO-A1-2013/113730
- JP-A- 2006 313 837
- US-A1- 2010 022 074
- US-A1- 2012 318 334
- US-A1- 2013 005 119
- US-B1- 8 530 337

## Beschreibung

Die vorliegende Erfindung bezieht sich auf ein Verfahren zum Erzeugen einer Festkörperschicht.

Festkörperschichten werden z.B. in der Halbleitertechnik sehr aufwendig und kostenintensiv hergestellt, wodurch bereits relativ kleine Verbesserungen deutliche Kosteneinsparungen oder Leistungsgewinne bewirken können.

Gemäß einem Artikel von Herrn Jan Oliver Löfken mit dem Titel "Extrem dünne Trennschicht hilft, die hauchdünnen Halbleiter-Stapel leichter von der Unterlage zu lösen" (Quelle http://www.wissenschaft-aktuell.de/artikel/Neues_Verfahren_fuer_blaue_und_weisse _Leuchtdioden_1771015588408.html) sind dünne Schichten aus dem Halbleiter Galliumnitrid der Schlüssel zu hell strahlenden blauen und weißen Leuchtdioden. Der Artikel offenbart ferner, dass eine extrem glatte und saubere Unterlage aus Saphir die notwendige Basis für dünne Galliumnitrid-Schichten bildet. Nur auf diesen künstlich hergestellten Substraten können danach die kristallinen Halbleiterschichten in der erforderlichen Qualität gezüchtet werden. Schwierig gestaltet sich dabei jedoch das Abtrennen der Galliumnitrid-Schichten mit aufwendigem Lasereinsatz, da Galliumnitrid stabile Bindungen mit dem Saphir-Träger aufbaut. Die Saphir-Unterlage wird deshalb zunächst mit einer nur drei millionstel Millimeter dünnen Schicht aus Bornitrid bedampft. Auf dieser stapelten sie danach mehrere Lagen aus Galliumnitrid, die teilweise mit den Elementen Aluminium und Indium versetzt wurden. Dieser Stapel entspricht im Prinzip bereits einer blauen Leuchtdiode, er muss jedoch noch von dem Saphirträger abgelöst werden. Mittels der zuvor aufgebrachten Trennschicht aus Bornitrid wird der gesamte Stapel dann rein mechanisch ohne Einsatz von Lasern vom Saphirträger abgehoben.

Diese Lösung ist nachteilig, da es beim rein mechanischen Abheben der erzeugten Schichten leicht zu einer Beschädigung der erzeugten Schichten oder des Trägersubstrats kommen kann.

Die US 2013/0 005 119 A1 beschreibt ein Verfahren zum Ablösen einer Halbleiterbauelementschicht von einem Basissubstrat. Das Verfahren umfasst das Bereitstellen einer Rissausbreitungsschicht auf einer oberen Oberfläche des Basissubstrats und das Herstellen einer Halbleiterbauelementschicht auf der Rissausbreitungsschicht. Die Rissausbreitungsschicht wird anschließend an den Rändern geätzt, um einen Riss zu erzeugen, und dann zerteilt, so dass ein erster Teil auf dem Basissubstrat und ein zweiter Teil auf der Halbleiterbauelementschicht verbleibt.

Es ist die Aufgabe der vorliegenden Erfindung, ein Verfahren zum Erzeugen von einer oder mehreren Festkörperschichten bereitzustellen, wobei das Risiko einer Beschädigung der erzeugten Schicht und/oder des Trägersubstrats reduziert werden soll.

Diese Aufgabe wird durch ein Verfahren zur Herstellung einer Festkörperschicht oder mehrerer Festkörperschichten oder einer Mehrschichtanordnung nach Anspruch 1 gelöst. Das erfindungsgemäße Verfahren umfasst mindestens die Schritte des Bereitstellens eines Trägersubstrats mit einer ersten exponierten Oberfläche und mit einer zweiten exponierten Oberfläche, des Erzeugens einer Ablöseschicht, die eine amorphe Schicht ist, in dem Trägersubstrat oder auf der ersten exponierten Oberfläche des Trägersubstrats, wobei die Ablöseschicht eine freiliegende Oberfläche aufweist, des Erzeugens der Festkörperschicht, insbesondere einer ersten Festkörperschicht, auf der freiliegenden Oberfläche der Ablöseschicht, wobei die Festkörperschicht eine zu der Ablöseschicht beabstandete freie Oberfläche aufweist, des Anordnens oder Ausbildens einer Aufnahmeschicht an der zweiten exponierten Oberfläche des Trägersubstrats oder an der freien Oberfläche der Festkörperschicht, des Erzeugens von Spannungen innerhalb der Ablöseschicht, wobei die Spannungen durch eine Temperierung von zumindest der Aufnahmeschicht erzeugt werden, wobei sich innerhalb der Ablöseschicht oder im Grenzbereich zwischen der Ablöseschicht und der Festkörperschicht in Folge der Spannungen ein Riss ausbreitet, wobei durch den Riss die Festkörperschicht von der zuvor erzeugten Mehrschichtanordnung abgespalten wird.

Diese Lösung ist vorteilhaft, da durch die Abtrennung der erzeugten Festkörperschicht von dem Trägersubstrat infolge einer thermisch induzierten Rissausbreitung innerhalb der Ablöseschicht flächenmäßig deutlich größere Festkörperschichten erzeugt werden können, da die bei der Risserzeugung und Rissausbreitung erfolgende Belastung der Festkörperschicht gegenüber dem aus dem Stand der Technik bekannten reinen "mechanischen Ablösen" deutlich geringer ist.

Weitere Ausführungsformen sind Gegenstand der Unteransprüche.

Gemäß einer bevorzugten Ausführungsform der vorliegenden Erfindung ist die Ablöseschicht derart konfiguriert, dass sie in zumindest einer mechanischen Eigenschaft, insbesondere der Bruchfestigkeit, signifikant von derselben mechanischen Eigenschaft einer weiteren Schicht, insbesondere von der Festkörperschicht, verschieden ist. Diese Ausführungsform ist vorteilhaft, da durch die unterschiedlichen mechanischen Eigenschaften die Rissauslösung und die Rissausbreitung vereinfacht werden.

Die Ablöseschicht wird gemäß einer weiteren bevorzugten Ausführungsform der vorliegenden Erfindung derart porös, insbesondere nanoporös, auf oder in dem Trägersubstrat erzeugt, dass die Bruchfestigkeit der Ablöseschicht geringer ist als die Bruchfestigkeit der Festkörperschicht. Anstelle von Poren ist ebenfalls denkbar, dass Defekte innerhalb der Ablöseschicht beim Erzeugen der Ablöseschicht oder nach der Erzeugung der Ablöseschicht erzeugt oder eingebracht werden, wobei durch die Defekte besonders bevorzugt die Bruchfestigkeit der Ablöseschicht reduziert wird. Diese Ausführungsform ist vorteilhaft, da die Erzeugung der Poren innerhalb der Ablöseschicht bevorzugt steuerbar ist und dadurch die gewünschten Eigenschaften definiert geschaffen bzw. eingestellt werden können. Die poröse Schicht ist ferner vorteilhaft, da sie nicht notwendigerweise, aber gegebenenfalls gegenüber einer epitaktisch erzeugten Schicht schneller erzeugt werden kann. Ferner kann eine poröse Ablöseschicht aus demselben Material bestehen, aus dem auch das Trägersubstrat besteht. Es ist jedoch ebenfalls denkbar, dass die Ablöseschicht dabei aus einem vom Material des Trägersubstrates verschiedenen Material bzw. Materialzusammensetzung besteht.

Die Ablöseschicht wird gemäß einer weiteren bevorzugten Ausführungsform der vorliegenden Erfindung auf dem Substrat aufgewachsen und mit einer Dotierung versehen, wobei mittels der Dotierung die Bruchfestigkeit der Ablöseschicht derart eingestellt bzw. beeinflusst wird, dass sie geringer ist als die Bruchfestigkeit der Festkörperschicht. Diese Ausführungsform ist vorteilhaft, da die Dotierung der Ablöseschicht sehr präzise vornehmbar ist, wodurch zumindest eine mechanische Eigenschaft, insbesondere die Bruchfestigkeit, gezielt manipulierbar bzw. einstellbar ist.

Zusätzlich oder alternativ ist es jedoch ebenfalls möglich, dass die Ablöseschicht durch die Umwandlung einer zuvor auf oder in dem Trägersubstrat erzeugten amorphen Schicht in eine kristalline Schicht erzeugt wird, wobei das Trägersubstrat in einem kristallinen Zustand vorliegt und durch die Umwandlung der amorphen Schicht in die kristalline Ablöseschicht die Kristallgitterinformationen des Kristallgitters des Trägersubstrates auf die Ablöseschicht übertragen werden. Diese Ausführungsform ist vorteilhaft, da sehr präzise eine sehr dünne Festkörperschicht erzeugt werden kann. Die Ablöseschicht dient dabei zum einen als Opferschicht, die leicht zerstört werden kann, wodurch die erzeugte Festkörperschicht einfach und prozesssicher von dem Trägersubstrat entfernt werden kann. Zum anderen gibt die Ablöseschicht die Kristallgitterinformationen des Trägermaterials beim Erzeugen der Festkörperschicht an die Festkörperschicht weiter. Besteht das Trägersubstrat z.B. aus Saphir, die Ablöseschicht aus Silizium und die Festkörperschicht ebenfalls aus Saphir, so kann die relativ geringere Festigkeit des Siliziums ausgenutzt werden, um die mit den Kristallgitterinformationen des Saphirträgersubstrats erzeugte Saphirfestkörperschicht von dem Saphirträgersubstrat zu trennen.

Anstelle oder zusätzlich zum Dotieren ist ebenfalls denkbar, dass Defekte innerhalb der Ablöseschicht beim Erzeugen der Ablöseschicht oder nach der Erzeugung der Ablöseschicht erzeugt oder eingebracht werden, wobei durch die Defekte wiederum besonders bevorzugt die Bruchfestigkeit der Ablöseschicht reduziert wird. Weiterhin ist denkbar, dass Poren in der Ablöseschicht erzeugt werden und zusätzlich eine Dotierung der Ablöseschicht erfolgt bzw. die Ablöseschicht teilweise oder vollständig dotiert wird. Die Ablöseschicht kann z.B. Bornitrit aufweisen oder aus Bornitrit bestehen.

Bevorzugt besteht die Festkörperschicht aus einem Grundlagenschichtanteil und aus einem Hauptschichtanteil, wobei der Grundlagenschichtanteil besonders bevorzugt unmittelbar oder mittelbar auf der amorphen Ablöseschicht erzeugt wird und der Hauptschichtanteil auf dem Grundlagenschichtanteil erzeugt wird. Der Grundlagenschichtanteil und Hauptschichtanteil bestehen bevorzugt aus demselben Material bzw. derselben Materialzusammensetzung. Es ist jedoch ebenfalls denkbar, dass der Grundlagenschichtanteil und der Hauptschichtanteil aus verschiedenen Materialien oder Materialzusammensetzungen bestehen.

Gemäß einer weiteren bevorzugten Ausführungsform der vorliegenden Erfindung breitet sich der Riss in einer Trennebene innerhalb der Ablöseschicht aus, wobei sich die Trennebene parallel zu der zweiten Oberfläche des Trägersubstrats und/oder parallel zu der an der Ablöseschicht angeordneten Oberfläche der Festkörperschicht erstreckt, wobei die Trennebene bevorzugt in einem Bereich in der Ablöseschicht liegt, der weiter von dem Trägersubstrat als von der Festkörperschicht beabstandet ist. Diese Ausführungsform ist vorteilhaft, da sie bewirkt, dass der an der Festkörperschicht verbleibende Anteil der Ablöseschicht sehr dünn ist bzw. sich gegenüber der Gesamterstreckung der Ablöseschicht in Y-Richtung bzw. in einer Richtung rechtwinklig zur flächenmäßig größten sich in einer Ebene erstreckenden Oberfläche der Ablöseebene geringer erstreckt als vor der Abtrennung bzw. Abspaltung. Bevorzugt weist der verbleibende Anteil der Ablöseschicht nach der Abspaltung eine Dicke auf, die geringer als die Hälfte, ein Viertel, ein Achtel oder ein Sechzehntel der Gesamtdicke der Ablöseschicht vor der Abspaltung ist. Der an der Festkörperschicht nach der Abspaltung verbleibende Anteil der Ablöseschicht wird bevorzugt spanend, insbesondere schleifend, und/oder chemisch abgelöst oder aufgelöst. Es ist ferner denkbar, dass die Festkörperschicht und die Ablöseschicht genau in einem Grenzbereich zwischen diesen Schichten voneinander abgetrennt bzw. abgespalten werden. Der Grenzbereich ist dabei bevorzugt der Bereich, in dem die Ablöseschicht und die Festkörperschicht miteinander in Kontakt stehen.

Die Ablöseschicht und die Festkörperschicht werden gemäß einer weiteren bevorzugten Ausführungsform der vorliegenden Erfindung zumindest teilweise jeweils durch Aufwachsen oder Aufdampfen erzeugt und die Festkörperschicht besteht bevorzugt aus einem Halbleitermaterial bzw. die Festkörperschicht weist bevorzugt ein Halbleitermaterial, insbesondere Galliumnitrit (GaN) oder Galliumarsenid (GaAs), auf. Es ist jedoch ebenfalls denkbar, dass die Ablöseschicht in einem ersten Schritt erzeugt wird und in einem weiteren Schritt an dem Trägersubstrat angeordnet bzw. angekoppelt wird. Weiterhin ist denkbar, dass das Trägersubstrat, insbesondere ohne Aufwachsen der Ablöseschicht, derart modifiziert wird, dass es, insbesondere ohne eine Dickenzunahme, eine innere Schicht ausbildet, die als Ablöseschicht dient und an der die Festkörpersicht mittelbar oder unmittelbar angeordnet, erzeugt oder aufgewachsen wird.

Die Festkörperschicht weist gemäß einer weiteren bevorzugten Ausführungsform eine Oberfläche auf, die größer oder gleich 10 cm² und bevorzugt größer oder gleich 100 cm² ist. Diese Ausführungsform ist vorteilhaft und aufgrund des erfindungsgemäßen Abspaltvorgang erst möglich, da derart großflächige Festkörperschichten, insbesondere bestimmter Halbleitermaterialien, bei einem rein mechanischen Abheben zerstört oder beschädigt werden würde.

Die Spannungen werden gemäß einer weiteren bevorzugten Ausführungsform der vorliegenden Erfindung durch eine Abkühlung von zumindest der Aufnahmeschicht, die bevorzugt aus einem Polymerwerkstoff, insbesondere aus PDMS, besteht, auf eine Temperatur von weniger als 10°C, insbesondere von weniger als 0°C und besonders bevorzugt von weniger als -100°C, erzeugt. Weiterhin ist denkbar, dass die Aufnahmeschicht auf die Glasübergangstemperatur des Materials der Aufnahmeschicht temperiert bzw. abgekühlt wird.

Zur Herstellung der Aufnahmeschicht ist bevorzugt PDMS Sylgard 184 von Dow Corning verwendbar. Dies ist ein zweikomponentiges Gemisch, das thermisch ausgehärtet wird (z.B. Mischverhältnisse zwischen Härter: Basismaterial von bevorzugt 1:100 bis 1:1 und besonders bevorzugt von 1:10 bis 1:3). Zum Härten sind - je nach Härtezeit - Raumtemperatur bis ca. 300°C und bevorzugt bis 200°C, vorzugsweise von Raumtemperatur bis ca. 120°C, vorsehbar. Bevorzugt sind Härtezeiten zwischen ca. 1-60 Minuten (bei hohen Temperaturen) und 1-6 Tagen (bei Raumtemperatur) vorsehbar. Bei PDMS Sylgard 184 handelt es sich vor dem Härten um eine viskose Flüssigkeit, die z.B. mittels Gießverfahren auf eine bevorzugt glatte Oberfläche (z.B. einen Spiegel) aufgebracht wird und dort zu einer Folie aushärtet wird, die auf die Festkörperschicht aufgeklebt wird. Alternativ ist es jedoch ebenfalls möglich die Aufnahmeschicht in situ an der Festkörperschicht zu erzeugen bzw. daran auszuhärten.

Es ergibt sich daher die Möglichkeit, durch unterschiedliche Bearbeitung des verwendeten Polymers (insbesondere unterschiedliche Härtung) je nach Bedarf Polymerschichten mit unterschiedlichen Elastizitätsmodulen herzustellen. Außerdem hängt das Elastizitätsmodul des verwendeten Polymers stark von der Temperatur ab (mit einem ausgeprägten Glas-übergang bei ca. -125°C, wo das Elastizitätsmodul um mehrere Größenordnungen ansteigt). Es ist deshalb auch möglich, durch gezieltes Erzeugen von Bereichen / Schichten unterschiedlicher Temperatur im Polymer entsprechende Bereiche / Schichten mit unterschiedlichem Elastizitätsmodul zu erzeugen. Auch andere physikalische Größen als die Temperatur können u.U. lokal das Elastizitätsmodul einer entsprechenden Polymerschicht beeinflussen und können dann zur gezielten Erzeugung von Bereichen / Schichten mit unterschiedlichem Elastizitätsmodul verwendet werden.

Gemäß einer weiteren bevorzugten Ausführungsform der vorliegenden Erfindung ist eine weitere Aufnahmeschicht vorgesehen, wobei die Aufnahmeschicht an der zweiten exponierten Oberfläche des Trägersubstrats ausgebildet ist und wobei die weitere Aufnahmeschicht an der freien Oberfläche der Festkörperschicht angeordnet ist. Diese Ausführungsform ist vorteilhaft, da die beiden durch die Abspaltung resultierenden Teile der ursprünglichen Mehrschichtanordnung sicher und stabil aufgenommen bzw. gehalten werden können. Weiterhin ist denkbar, dass mittels der Aufnahmeschichten Spannungen über einander gegenüberliegende Oberflächen der Mehrschichtanordnung in die Mehrschichtanordnung eingeleitet werden können. Alternativ ist jedoch ebenfalls denkbar, dass das Trägersubstrat mittels einer Halteeinrichtung fixiert wird, während die Aufnahmeschicht derart thermisch beaufschlagt wird, dass Spannungen zum Abspalten der Festkörperschicht innerhalb der Ablöseschicht erzeugt werden.

Gemäß einer weiteren bevorzugten Ausführungsform der vorliegenden Erfindung wird mindestens eine weitere Festkörperschicht vor dem Abspalten der ersten Festkörperschicht an der Mehrschichtanordnung erzeugt oder angeordnet, wobei die weitere Festkörperschicht bevorzugt ebenfalls infolge thermisch induzierter Spannungen von der Mehrschichtanordnung abgespalten wird oder wobei die weitere Festkörperschicht zusammen mit der ersten Festkörperschicht abgespalten wird. Es ist hierbei denkbar, dass eine oder mehrere weitere Festkörperschichten, insbesondere z.B. mindestens, genau oder maximal 2, 3, 4, 5, 6, 7, 8, 9, 10, 15, 20, 25 oder 30 Festkörperschichten, an der Mehrschichtanordnung erzeugt oder angeordnet werden. Bevorzugt weisen die erste Festkörperschicht und die zweite Festkörperschicht das gleiche Material oder verschiedene Materialien auf. Bevorzugt bestehen die erste Festkörperschicht und die weitere Festkörperschicht aus dem gleichen Material. Weiterhin ist denkbar, dass die erste Festkörperschicht und die weitere Festkörperschicht zeitgleich oder zeitversetzt an der Mehrschichtanordnung ausgebildet bzw. angeordnet bzw. aufgewachsen werden.

Es kann mindestens eine weitere Festkörperschicht, insbesondere aus Galliumnitrit, vorgesehen sein, wobei die weitere Festkörperschicht zusammen mit der ersten Festkörperschicht abgespalten wird.

Ein weiteres Trägersubstrat an der Festkörperschicht oder an einer weiteren Festkörperschicht erzeugt oder angeordnet werden, insbesondere angebondet werden, wobei die erste Festkörperschicht und/oder die mindestens oder genau eine weitere Festkörperschicht oder mehrere weitere Festkörperschichten nach der Abspaltung mit dem weiteren Trägersubstrat, insbesondere einer Glas oder Siliciumschicht, eine Mehrschichtanordnung ausbildet. Diese Ausführungsform ist vorteilhaft, da die erzeugte Festkörperschicht oder die erzeugten Festkörperschichten mittels des weiteren Trägersubstrats einfach weiterverarbeitet werden können.

Die Dicke der Ablöseschicht kann kleiner als 1µm, bevorzugt kleiner als 100nm bzw. kleiner als 50nm und besonders bevorzugt kleiner als 10nm sein. Dies Ausführungsform ist vorteilhaft, da die Ablöseschicht so nur einen sehr geringen Materialverbrauch bewirkt. Ferner sind die nach dem Trennen der Ablöseschicht eventuell zu entfernenden Materialanteile der Ablöseschicht von der Festkörperschicht sehr gering.

Weitere Vorteile, Ziele und Eigenschaften der vorliegenden Erfindung werden anhand nachfolgender Beschreibung anliegender Zeichnungen erläutert, in welchen beispielhaft die Erzeugung der erfindungsgemäßen Festkörperschicht dargestellt ist. Elemente der erfindungsgemäßen Festkörperschichtherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigen:
- Fig. 1a-1e: Verschiedene Schichtanordnungen gemäß dem erfindungsgemäßen Verfahren;
- Fig. 2a und 2b: weitere Schichtanordnungen gemäß dem erfindungsgemäßen Verfahren;
- Fig. 3a-3d: eine weitere erfindungsgemäße Schichtanordnungsvariante mit einer weiteren Trägerschicht;
- Fig. 4a-4d: verschiedene Beispiel hinsichtlich der Erzeugung der Spannungen innerhalb der Ablöseschicht;
- Fig. 5a-5d: eine weitere erfindungsgemäße Schichtenanordnungsvariante mit einer weiteren Trägerschicht und mindestens einer weiteren Festkörpersch icht;
- Fig. 6a-6d: verschiedene Beispiel hinsichtlich der Erzeugung der Spannungen innerhalb der Ablöseschicht bei einer Schichtanordnung im Sinne der Figuren 5c und/oder 5d;
- Fig. 7: zeigt schematisch eine Kompositanordnung vor und nach dem Splitten; und
- Fig. 8a-8c: zeigen schematisch Anordnungen zur Übertragung der Gitterinformation eines kristallinen Trägersubstrats auf die zu erzeugende Festkörperschicht.

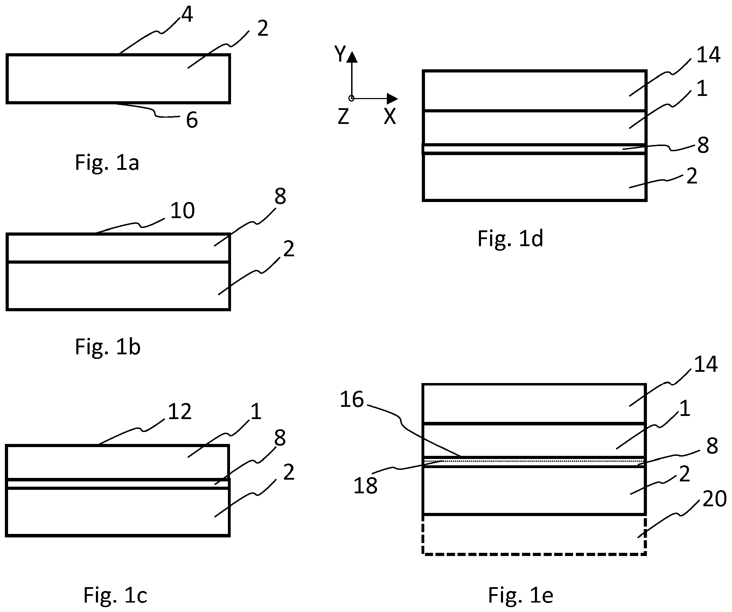

Fig. 1a zeigt ein Trägersubstrat 2, das sich bevorzugt eben erstreckt, d.h. eine erste ebene bzw. im Wesentlichen ebene exponierte Oberfläche 4 und eine zweite ebene bzw. im Wesentlichen ebene exponierte Oberfläche 6 aufweist. Die erste exponierte Oberfläche 4 des Trägersubstrats 2 ist bevorzugt parallel oder im Wesentlichen parallel zu der zweiten exponierten Oberfläche 6 des Trägersubstrats 2 beabstandet. Das Trägersubstrat 2 kann zumindest teilweise oder vollständig aus einem Material bestehen, das Saphir und/oder Silizium und/oder Siliziumcarbid aufweist. Es ist jedoch ebenfalls denkbar, dass das Trägersubstrat 2 vollständig oder ausschließlich oder zu mehr als 90% aus Saphir und/oder Silizium und/oder Siliziumcarbid besteht.

In Fig. 1b ist gegenüber der Fig. 1a eine weitere Schicht auf dem Trägersubstrat 2, insbesondere einerseits bzw. auf der ersten exponierten Oberfläche 4 des Trägersubstrats 2, ausgebildet. Bei der weiteren Schicht handelt es sich bevorzugt um eine aufgewachsene Schicht, insbesondere um eine aufgewachsene Ablöseschicht 8. Die Ablöseschicht 8 wird als eine amorphe Schicht erzeugt. Weiterhin ist jedoch denkbar, dass die Ablöseschicht 8 erst erzeugt wird und dann mit dem Trägersubstrat 2 verbunden bzw. mit diesem gekoppelt wird. Es ist ferner denkbar, dass das Trägersubstrat 2 noch eine oder mehrere Beschichtungen aufweist und die Ablöseschicht 8 an einer dieser Schichten angeordnet bzw. erzeugt wird. Das Bezugszeichen 10 kennzeichnet eine freiliegende Oberfläche, an der oder oberhalb von der (in Y-Richtung) eine Festkörperschicht 1 erzeugt bzw. ausgebildet wird (vgl. Fig. 1c). Die Ablöseschicht 8 ist bevorzugt weniger als 100µm, besonders bevorzugt weniger als 50µm und höchst bevorzugt weniger als 20µm dick bzw. erstreckt sich bevorzugt nur soweit in Dickenrichtung bzw. in Y-Richtung. Bevorzugt weist die Ablöseschicht 8 eine Bruchfestigkeit auf, die geringer ist als die Bruchfestigkeit einer weiteren Schicht, insbesondere der Festkörperschicht 1 oder des Trägersubstrats 2.

Gemäß Fig. 1c ist die Festkörperschicht 1 an der Ablöseschicht 8 bzw. auf der Ablöseschicht 8 ausgebildet. Bei der Festkörperschicht 1 handelt es sich bevorzugt um eine aufgewachsene Schicht. Es ist ferner denkbar, dass die Ablöseschicht 8 noch eine oder mehrere Beschichtungen aufweist und die Festkörperschicht 1 an einer dieser Schichten angeordnet bzw. erzeugt wird. Die Festkörperschicht 1 kann hierbei als eine Schicht ausgebildet sein bzw. werden, die bevorzugt ein Halbleitermaterial, wie z.B. Galliumphosphid (GaP), Indiumphosphid (InP), Indiumantimonid (InSb), Indiumarsenid (InAs), Galliumantimonid (GaSb), Galliumnitrid (GaN), Aluminiumnitrid (AIN), Indiumnitrid (InN), Aluminiumgalliumarsenid (AlₓGA₁₋ₓAs) und/oder Indiumgalliumnitrid (InₓGa₁₋ₓN), aufweist oder daraus besteht. Das Bezugszeichen 12 kennzeichnet eine freie Oberfläche der Festkörperschicht 1. Die freie Oberfläche 12 ist bzw. wird bevorzugt eben oder im Wesentlichen eben ausgebildet. Besonders bevorzugt ist die freie Oberfläche 12 parallel oder im Wesentlichen parallel zu der Oberfläche 10 der Ablöseschicht 8 ausgerichtet.

Fig. 1d zeigt, dass eine Aufnahmeschicht 14 an der Mehrschichtanordnung zumindest bestehend aus dem Trägersubstrat 2, der Ablöseschicht 8 und der Festkörperschicht 1 angeordnet bzw. erzeugt ist. Die Aufnahmeschicht 14 ist in dieser Darstellung an der zunächst freien Oberfläche 12 der Festkörperschicht 1 angebracht bzw. ausgebildet. Zusätzlich oder alternativ ist jedoch ebenfalls denkbar, dass die Aufnahmeschicht 14 an der zweiten exponierten Oberfläche 6 des Trägersubstrats 2 angeordnet, ausgebildet oder erzeugt wird. Die Aufnahmeschicht 14 kann bevorzugt jederzeit an dem Trägersubstrat 2 angeordnet, ausgebildet oder erzeugt werden, d.h. die Aufnahmeschicht 14 kann z.B. vor der Erzeugung bzw. Anordnung der Ablöseschicht 8 oder vor der Erzeugung bzw. Anordnung der Festkörperschicht 1 an dem Trägersubstrat 2 angeordnet bzw. erzeugt werden.

Bevorzugt ist neben der Aufnahmeschicht 14 eine weitere Aufnahmeschicht 20 (vgl. Fig. 1e) vorgesehen. Sollten mehrere Aufnahmeschichten vorgesehen werden, dann ist denkbar, dass sich die einzelnen Aufnahmeschichten 14, 20 in ihren Eigenschaften unterscheiden. Besonders bevorzugt bestehen die einzelnen Aufnahmeschichten 14, 20 jedoch zumindest teilweise aus demselben Material, insbesondere aus Polydimethylsiloxane (PDMS). Bevorzugt ist die Aufnahmeschicht 14 bzw. sind die Aufnahmeschichten 14, 20 vorgefertigte folienartige Schichten, die besonders bevorzugt mittels eines Klebers, insbesondere flüssigem PDMS, an dem Trägersubstrat 2 und/oder an der Festkörperschicht 1 angebracht werden. Es ist jedoch alternativ auch denkbar, dass eine oder beide Aufnahmeschichten 14, 20 in situ erzeugt werden.

In Fig. 1e ist die in Fig. 1d gezeigte Darstellung durch eine gestrichelt dargestellte weitere Aufnahmeschicht 20 ergänzt. Wie bzgl. Fig. 1d ausgeführt wurde, kann die weitere Aufnahmeschicht 20 optional sein. Es ist somit denkbar, dass nur eine Aufnahmeschicht 14 vorgesehen, erzeugt, angeordnet oder ausgebildet wird, wobei die eine Aufnahmeschicht 14 dann an dem Trägersubstrat 2 oder an der Festkörperschicht 1 vorgesehen, erzeugt, angeordnet oder ausgebildet werden kann.

Das Bezugszeichen 16 kennzeichnet einen Grenzbereich zwischen der Ablöseschicht 8 und der Festkörperschicht 1. Der Grenzbereich 16 stellt bevorzugt die Schnittstelle zwischen der Oberfläche 10 und der Festkörperschicht 1 dar. Weiterhin kennzeichnet das Bezugszeichen 18 beispielhaft eine Trennebene, innerhalb der sich ein Riss zum Abtrennen der Festkörperschicht 1 ausbreitet. Bevorzugt ist die Trennebene 16 nur wenige µm, insbesondere weniger als 20 µm oder weniger als 10 µm oder weniger als 5 µm, von dem Grenzbereich 18 beabstandet.

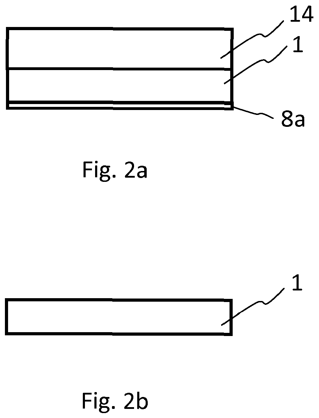

In Fig. 2a ist ein Beispiel für einen möglichen Schichtaufbau nach der Spaltung der Ablöseschicht 8 gezeigt. An der Festkörperschicht 1 ist einerseits weiterhin der abgespaltete Rest der Ablöseschicht 8 angeordnet bzw. anhaftend und andererseits weiterhin die Aufnahmeschicht 14 angeordnet bzw. anhaftend.

In Fig. 2b ist lediglich die erzeugte Festkörperschicht 1 gezeigt. Der in Fig. 2a gezeigte verbleibende Anteil 8a der Ablöseschicht 8 und die Aufnahmeschicht 14 wurden bzw. sind von der Festkörperschicht 1 entfernt. Es ist hierbei denkbar, dass der Anteil 8a der Ablöseschicht 8 und die Aufnahmeschicht 14 nacheinander oder zeitgleich mittels spanenden, thermischen, chemischen und/oder mechanischen Verfahren entfernt werden. Bevorzugt wird für die Entfernung des verbleibenden Anteils 8a der Ablöseschicht 8 ein anderes Verfahren verwendet als für das Entfernen der Aufnahmeschicht 14.

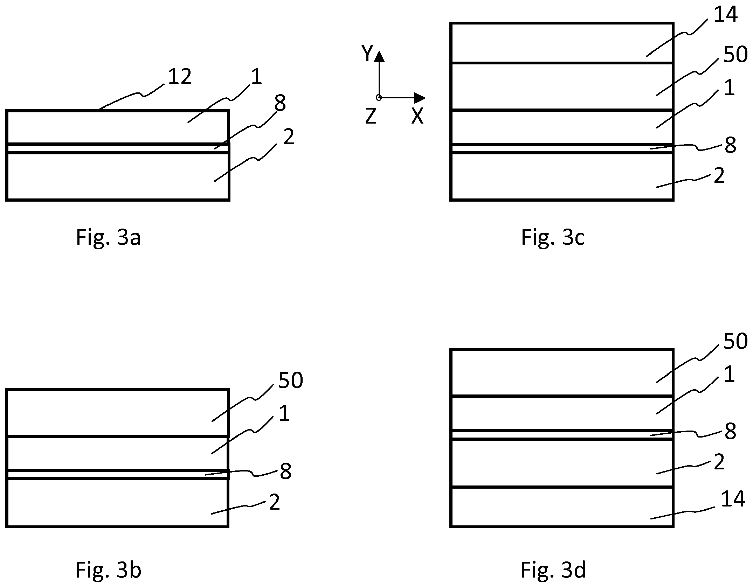

Fig. 3a zeigt eine Schichtenanordnung, wie sie bereits gemäß Fig. 1c beschrieben ist. Gemäß der Fig. 3b wird auf der ersten Festkörperschicht 1 eine weitere Trägerschicht bzw. ein weiteres Trägersubstrat 50 ausgebildet, erzeugt oder angeordnet, insbesondere angebondet. Das Trägersubstrat 50 kann hierbei z.B. als Glasschicht, Siliziumschicht oder Saphirschicht ausgebildet sein/werden. Es ist jedoch ebenfalls denkbar, dass das Trägersubstrat 50 aus anderen Materialien oder Materialkombinationen besteht.

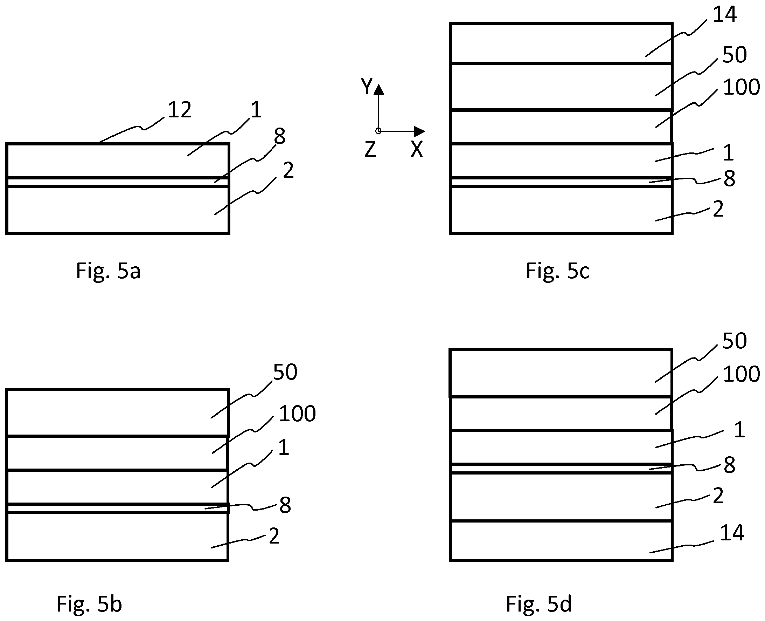

In den Figuren 3c und 3d ist entweder einerseits des Trägersubstrats 2 oder einerseits des weiteren Trägersubstrats 50 die Aufnahmeschicht 14 angeordnet oder ausgebildet. Bevorzugt ist die Aufnahmeschicht 14 einerseits einer dieser Trägersubstrate 2, 50 angeordnet, wobei einerseits des anderen Trägersubstrats eine weitere Aufnahmeschicht 20 angeordnet wird. Bevorzugt ist die Aufnahmeschicht 14 direkt an einem Trägersubstrat 2 oder 50 angeordnet, dies gilt besonders bevorzugt ebenfalls für die weitere Aufnahmeschicht 20. Somit wird ein weiteres Trägersubstrat 50 an der Festkörperschicht 1 oder an einer weiteren Festkörperschicht 100 (vgl. Fig. 5b) erzeugt oder angeordnet, insbesondere angebondet, wobei die erste Festkörperschicht 1 und/oder die weitere Festkörperschicht 100 (vgl. Fig. 5b) nach der Abspaltung mit dem weiteren Trägersubstrat 50, insbesondere einer Glas oder Siliziumschicht, eine Mehrschichtanordnung ausbildet.

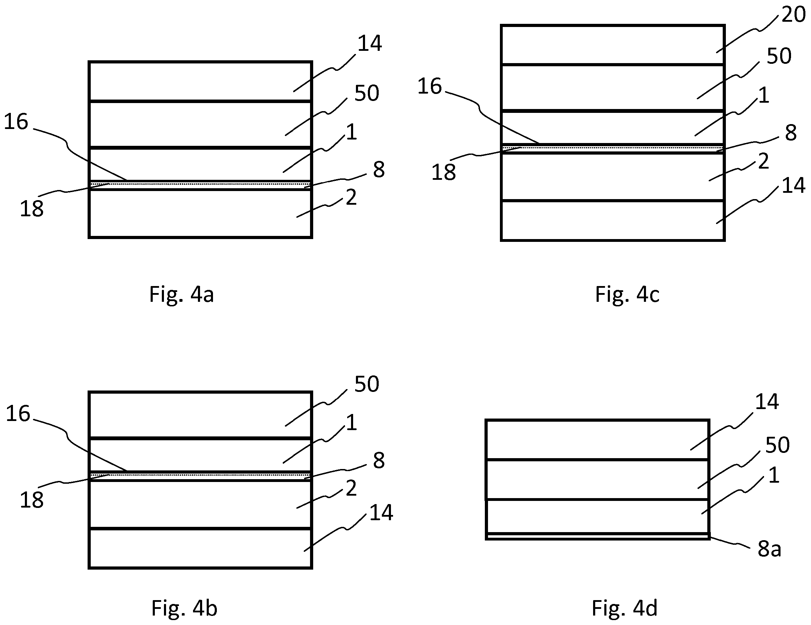

In der Fig. 4a ist die Aufnahmeschicht 14 an der weiteren Trägerschicht 50 bzw. einerseits der weiteren Trägerschicht 50 angeordnet. In Fig. 4b ist die Aufnahmeschicht 14 an der Trägerschicht 2 bzw. einerseits der Trägerschicht 2 angeordnet. Gemäß Fig. 4c ist die weitere Aufnahmeschicht 20 einerseits des weiteren Trägersubstrats 50 oder an dem weiteren Trägersubstrat 50 angeordnet und die Aufnahmeschicht 14 ist einerseits an dem Trägersubstrat 2 angeordnet oder an dem Trägersubstrat 2 angeordnet.

Fig. 4d zeigt eine erfindungsgemäße Mehrschichtanordnung, wie sie bevorzugt nach der Abspaltung ausgestaltet ist. Es ist hierbei denkbar, dass der verbleibende Teil 8a der Ablöseschicht 8 und/oder die Aufnahmeschicht 14 entfernt werden/wird.

Fig. 5a zeigt eine Schichtenanordnung, wie sie bereits gemäß Fig. 1c beschrieben ist.

Gemäß der Fig. 5b ist zwischen der ersten Festkörperschicht 1 und der weiteren Trägerschicht 50 eine weitere Festkörperschicht 100 angeordnet, erzeugt oder ausgebildet. Es ist hierbei denkbar, dass neben der weiteren Festkörperschicht 100 noch genau, mindestens oder maximal oder bis zu 1, 2, 3, 4, 5, 6, 7, 8, 9, 10, 15, 20 weitere Festkörperschichten angeordnet, ausgebildet oder erzeugt werden können. Weiterhin ist denkbar, dass anstelle des weiteren Trägersubstrats 50 an der weiteren Festkörperschicht 100 die Aufnahmeschicht 14 angeordnet oder erzeugt wird.

In den Figuren 5c und 5d ist entweder einerseits des Trägersubstrats 2 oder einerseits des weiteren Trägersubstrats 50 die Aufnahmeschicht 14 angeordnet oder ausgebildet. Bevorzugt ist die Aufnahmeschicht 14 einerseits eines dieser Trägersubstrate 2, 50 angeordnet, wobei einerseits des anderen Trägersubstrats eine weitere Aufnahmeschicht 20 angeordnet wird. Bevorzugt ist die Aufnahmeschicht 14 direkt an einem Trägersubstrat 2 oder 50 angeordnet, dies gilt besonders bevorzugt ebenfalls für die weitere Aufnahmeschicht 20.

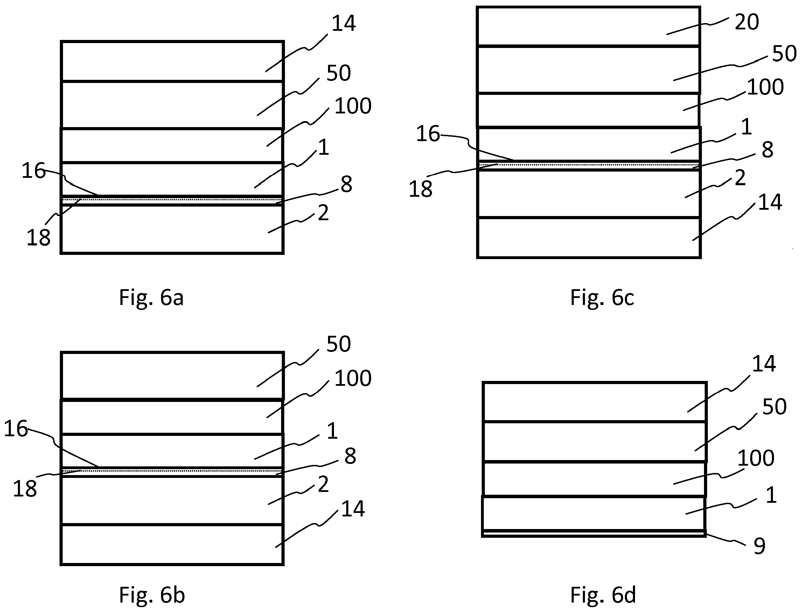

In der Fig. 6a ist die Aufnahmeschicht 14 an der weiteren Trägerschicht 50 bzw. einerseits der weiteren Trägerschicht 50 angeordnet. In Fig. 6b ist die Aufnahmeschicht 14 an der Trägerschicht 2 bzw. einerseits der Trägerschicht 2 angeordnet. Gemäß Fig. 6c ist die weitere Aufnahmeschicht 20 einerseits des weiteren Trägersubstrats 50 oder an dem weiteren Trägersubstrat 50 angeordnet und die Aufnahmeschicht 14 ist einerseits des Trägersubstrats 2 oder an dem Trägersubstrat 2 angeordnet.

Fig. 6d zeigt eine erfindungsgemäße Mehrschichtanordnung, wie sie bevorzugt nach der Abspaltung ausgestaltet ist. Es ist hierbei denkbar, dass der verbleibende Teil 8a der Ablöseschicht 8 und/oder die Aufnahmeschicht 14 entfernt wird.

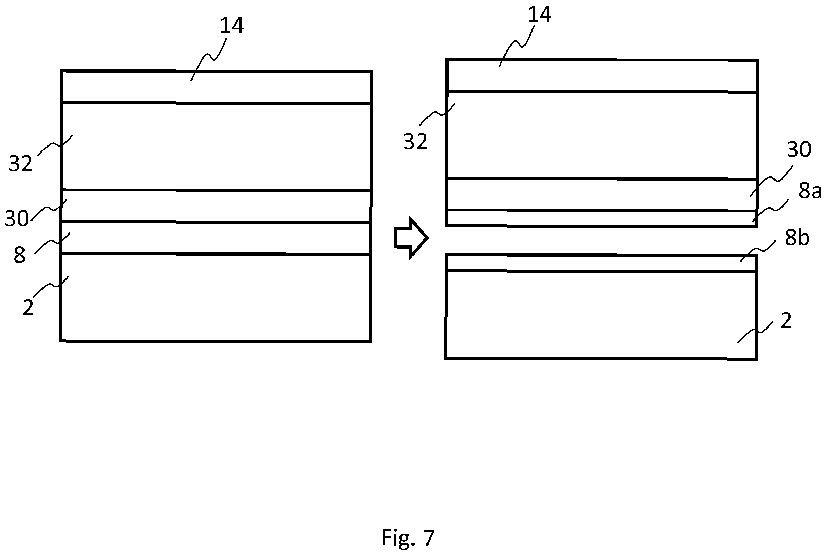

Fig. 7 zeigt eine Kompositstruktur, in der die Ablöseschicht auf oder in dem Trägersubstrat als eine amorphe Schicht erzeugt wird. Die Festkörperschicht 1 besteht dabei aus einem Grundlagenschichtanteil 30 und aus einem Hauptschichtanteil 32, wobei der Grundlagenschichtanteil 30 auf der amorphen Ablöseschicht 8 erzeugt wird und der Hauptschichtanteil 32 auf dem Grundlagenschichtanteil 30 erzeugt wird. Der Pfeil symbolisiert hierbei den Splitvorgang und zeigt auf den Zustand nach dem Splitvorgang. Nach dem Spitvorgang ist die Ablöseschicht 8 in einen ersten Anteil 8a und in einen zweiten Anteil 8b aufgeteilt. Der ersten Anteil 8a ist weiterhin mit der abgetrennten Festkörperschicht 1 verbunden und der zweite Anteil 8b ist weiterhin mit dem Trägersubstrat 2 verbunden.

Gemäß einer vorteilhaften Materialkombination weist das Trägersubstrat 2 bevorzugt Silizium auf oder besteht bevorzugt aus Silizium, die Ablöseschicht 8 weist bevorzugt amorphes Silizium auf oder besteht bevorzugt aus amorphem Silizium, der Grundlagenschichtanteil 30 besteht bevorzugt aus einem Grundlagenschichtmaterial, insbesondere aus Silizium, und der Hauptschichtanteil 32 weist bevorzugt Silizium auf oder besteht bevorzugt aus Silizium. Durch diese Materialkombination lassen sich auf vorteilhafte Weise Festkörperschichten aus Silizium herstellen, die z.B. für Photovoltaikanwendungen oder ähnliche Anwendungen zur Wafererzeugung geeignet sind.

Gemäß einer weiteren vorteilhaften Materialkombination weist das Trägersubstrat 2 bevorzugt Silizium oder Saphier auf oder besteht bevorzugt aus Silizium oder Saphir, die Ablöseschicht 8 weist bevorzugt amorphes Silizium oder Saphir auf oder besteht bevorzugt aus amorphem Silizium oder Saphir, der Grundlagenschichtanteil 30 besteht bevorzugt aus einem Grundlagenschichtmaterial, insbesondere aus Saphir, und der Hauptschichtanteil 32 weist bevorzugt Saphir auf oder besteht bevorzugt aus Saphir. Durch diese Materialkombination lassen sich auf vorteilhafte Weise Festkörperschichten aus Saphir herstellen, die z.B. für Displayanwendungen geeignet sind.

Gemäß einer noch weiteren vorteilhaften Materialkombination weist das Trägersubstrat 2 bevorzugt Silizium oder Saphier oder Siliziumcarbid auf oder besteht bevorzugt aus Silizium oder Saphir oder Siliziumcarbid, die Ablöseschicht 8 weist bevorzugt amorphes Silizium oder Saphir oder Siliziumcarbid auf oder besteht bevorzugt aus amorphem Silizium oder Saphir oder Siliziumcarbid, der Grundlagenschichtanteil 30 besteht bevorzugt aus einem Grundlagenschichtmaterial, insbesondere aus Siliziumcarbid, und der Hauptschichtanteil 32 weist bevorzugt Siliziumcarbid auf oder besteht bevorzugt aus Siliziumcarbid. Durch diese Materialkombination lassen sich auf vorteilhafte Weise Festkörperschichten aus Siliziumcarbid herstellen.

Der am Trägersubstrat 2 verbleibende Anteil 8b der Ablöseschicht 8 wird bevorzugt aufbereitet und/oder zur Erzeugung einer weiteren Festkörperschicht 1 verwendet.

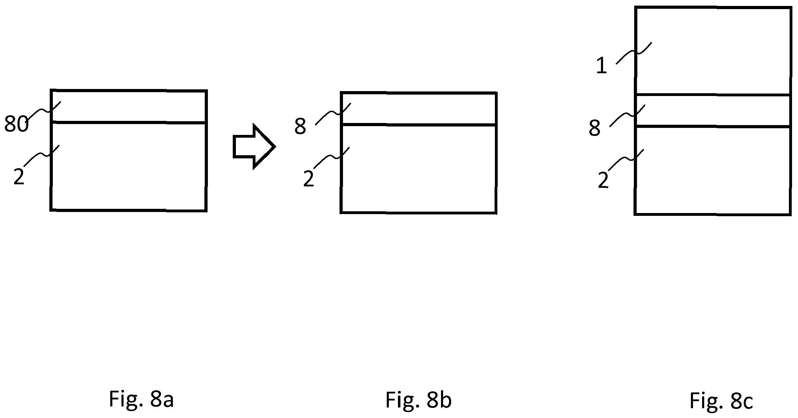

Fig. 8a zeigt eine auf einem Trägersubstrat 2 angeordnete Ausgangsschicht 80, die in einem amorphen Zustand vorliegt. Der Pfeil zwischen Fig. 8a und 8b gibt an, dass die amorphe Ausgangsschicht 80 aus Fig. 8a durch eine Behandlung, insbesondere ein Temperverfahren, in eine kristalline Schicht überführt wird, wodurch sich die Ablöseschicht 8 ergibt.

Die Ablöseschicht 8 kann somit beispielsweise durch die Umwandlung einer zuvor auf oder in dem Trägersubstrat 2 erzeugten amorphen Schicht 80 in eine kristalline Schicht erzeugt werden, wobei das Trägersubstrat 2 in einem kristallinen Zustand vorliegt und durch die Umwandlung der amorphen Schicht in die kristalline Ablöseschicht 8 die Kristallgitterinformation des Kristallgitters des Trägersubstrates 2 auf die Ablöseschicht 8 übertragen werden. Eine gemäß Fig. 8c z.B. mittels Epitaxie auf der kristallinen Ablöseschicht 8 erzeugte Festkörperschicht 1 kann somit mit der Kristallgitterinformation des Trägersubstrates 2 erzeugt werden, ohne jedoch unmittelbar an dem Trägersubstrat 2 angeordnet sein zu müssen. Das Tägersubstrat 2 kann hierbei z.B. Saphir sein und die Ablöseschicht 8 kann z.B. aus kristallinem Silizium bestehen und die Festkörperschicht 1 kann z.B. aus Saphir oder Siliziumcarbid bestehen.

Alternativ zur Umwandlung eines amorphen Materials in ein kristallines Material kann jedoch ebenfalls die Ablöseschicht in kristalliner Form auf dem Trägersubstrat erzeugt werden, dies ist beispielsweise mittels Epitaxie möglich.

### Bezugszeichenliste

- 1: Festkörperschicht
- 2: Trägersubstrat
- 4: Erste exponierte Oberfläche
- 6: Zweite exponierte Oberfläche
- 8: Ablöseschicht
- 8a: erster Anteil der Ablöseschicht
- 8b: zweiter Anteil der Ablöseschicht
- 9: Teil der Ablöseschicht
- 10: Freiliegende Oberfläche
- 12: Freie Oberfläche
- 14: Aufnahmeschicht
- 16: Grenzbereich
- 18: Trennebene
- 20: Weitere Aufnahmeschicht
- 30: Grundlagenschichtanteil
- 32: Hauptschichtanteil
- 50: Weiteres Trägersubstrat
- 80: Ausgangsschicht
- 100: Weitere Festkörperschicht

## Patentansprüche

1. Verfahren zur Herstellung zumindest einer Festkörperschicht (1), mindestens umfassend die Schritte:
Bereitstellen eines Trägersubstrats (2) mit einer ersten exponierten Oberfläche (4) und mit einer zweiten exponierten Oberfläche (6);
Erzeugen einer Ablöseschicht (8) in dem Trägersubstrat (2) oder auf der ersten exponierten Oberfläche (4) des Trägersubstrats (2), wobei die Ablöseschicht (8) eine freiliegende Oberfläche (10) aufweist;
Erzeugen einer ersten Festkörperschicht (1) auf der freiliegenden Oberfläche (10) der Ablöseschicht (8), wobei die erste Festkörperschicht (1) eine zu der Ablöseschicht (8) beabstandete freie Oberfläche (12) aufweist;
Anordnen oder Ausbilden einer Aufnahmeschicht (14) an der zweiten exponierten Oberfläche (6) des Trägersubstrats (2) oder an der freien Oberfläche (12) der ersten Festkörperschicht (1);
Erzeugen von Spannungen innerhalb der Ablöseschicht (8),
wobei die Spannungen durch eine Temperierung von zumindest der Aufnahmeschicht (14) erzeugt werden,
wobei sich innerhalb der Ablöseschicht (8) oder im Grenzbereich (16) zwischen der Ablöseschicht (8) und der Festkörperschicht (1) in Folge der Spannungen ein Riss ausbreitet, wobei durch den Riss die erste Festkörperschicht (1) von der zuvor erzeugten Mehrschichtanordnung abgespalten wird,
**dadurch gekennzeichnet, dass**
die Ablöseschicht (8) auf oder in dem Trägersubstrat (2) als eine amorphe Schicht erzeugt wird.

2. Verfahren nach Anspruch 1,
**dadurch gekennzeichnet, dass**
die Ablöseschicht (8) derart konfiguriert ist, dass sie in zumindest einer mechanischen Eigenschaft, insbesondere der Bruchfestigkeit, signifikant von derselben mechanischen Eigenschaft einer weiteren Schicht, insbesondere von der ersten Festkörperschicht (1), verschieden ist.

3. Verfahren nach Anspruch 1 oder 2,
**dadurch gekennzeichnet, dass**
die Ablöseschicht (8) derart auf oder in dem Trägersubstrat (2) erzeugt, insbesondere aufgewachsen, wird, dass die Bruchfestigkeit der Ablöseschicht (8) geringer ist als die Bruchfestigkeit der ersten Festkörperschicht (1).

4. Verfahren nach Anspruch 1 oder 2,
**dadurch gekennzeichnet, dass**
die Ablöseschicht (8) auf dem Trägersubstrat (1) aufgewachsen und mit einer Dotierung versehen wird,
wobei mittels der Dotierung die Bruchfestigkeit der Ablöseschicht (8) derart eingestellt wird, dass sie geringer ist als die Bruchfestigkeit der ersten Festkörperschicht (1) oder wobei die Ablöseschicht (8) durch die Umwandlung einer zuvor auf oder in dem Trägersubstrat (2) erzeugten amorphen Schicht in eine kristalline Schicht erzeugt wird,
wobei das Trägersubstrat (2) in einem kristallinen Zustand vorliegt und durch die Umwandlung der amorphen Schicht in die kristalline Ablöseschicht (8) die Kristallgitterinformation des Kristallgitters des Trägersubstrates (2) auf die Ablöseschicht (8) übertragen werden.

5. Verfahren nach Anspruch 4,
**dadurch gekennzeichnet, dass**
die Ablöseschicht (8) und die Festkörperschicht (1) zumindest teilweise jeweils durch Aufwachsen erzeugt werden und insbesondere die erste Festkörperschicht (1) bevorzugt aus Galliumnitrit (GaN) besteht.

6. Verfahren nach Anspruch 1,
**dadurch gekennzeichnet, dass**
die Festkörperschicht (1) aus einem Grundlagenschichtanteil (30) und aus einem Hauptschichtanteil (32) besteht, wobei der Grundlagenschichtanteil (30) auf der amorphen Ablöseschicht (8) erzeugt wird und der Hauptschichtanteil (32) auf dem Grundlagenschichtanteil (30) erzeugt wird.

7. Verfahren nach mindestens einem der vorangegangenen Ansprüche,
**dadurch gekennzeichnet, dass**
sich der Riss in einer Trennebene (18) innerhalb der Ablöseschicht (8) ausbreitet,
wobei sich die Trennebene (18) parallel zu der zweiten exponierten Oberfläche (6) des Trägersubstrats (2) und parallel zu der an der Ablöseschicht (8) angeordneten Oberfläche der ersten Festkörperschicht (1) erstreckt,
wobei die Trennebene (18) in einem Bereich in der Ablöseschicht (8) liegt, der weiter von dem Trägersubstrat (2) als von der ersten Festkörperschicht (1) beabstandet ist.

8. Verfahren nach mindestens einem der vorangegangenen Ansprüche,
**dadurch gekennzeichnet, dass**
die Spannungen durch eine Abkühlung von zumindest der Aufnahmeschicht (14), die bevorzugt aus einem Polymerwerkstoff, insbesondere aus PDMS, besteht, auf eine Temperatur von weniger als 10°C, insbesondere von weniger als 0°C und besonders bevorzugt von weniger als -100°C, erzeugt werden.

9. Verfahren nach mindestens einem der vorangegangenen Ansprüche,
**dadurch gekennzeichnet, dass**
eine weitere Aufnahmeschicht (20) vorgesehen ist, wobei die Aufnahmeschicht (14) an der zweiten exponierten Oberfläche (6) des Trägersubstrats (2) ausgebildet ist und wobei die weitere Aufnahmeschicht (20) an der freien Oberfläche (12) der Festkörperschicht (1) angeordnet ist.

10. Verfahren nach mindestens einem der vorangegangenen Ansprüche,
**dadurch gekennzeichnet, dass**
mindestens eine weitere Festkörperschicht (100) vor dem Abspalten der ersten Festkörperschicht (1) an der Mehrschichtanordnung erzeugt oder angeordnet wird, wobei die weitere Festkörperschicht (100) zusammen mit der ersten Festkörperschicht (1) abgespalten wird.

11. Verfahren nach mindestens einem der vorangegangenen Ansprüche,
**dadurch gekennzeichnet, dass**
ein weiteres Trägersubstrat (50) an der Festkörperschicht (1) oder an einer weiteren Festkörperschicht (100) erzeugt oder angeordnet, insbesondere angebondet, wird, wobei die erste Festkörperschicht (1) und/oder die weitere Festkörperschicht (100) nach der Abspaltung mit dem weiteren Trägersubstrat (50), insbesondere einer Glas-oder Siliciumschicht, eine Mehrschichtanordnung ausbildet.

12. Verfahren nach einem der zuvor genannten Ansprüche,
**dadurch gekennzeichnet, dass**
die Dicke der Ablöseschicht (8) kleiner als 1µm, bevorzugt kleiner als 100nm und besonders bevorzugt kleiner als 10nm ist.

## Claims

1. Method for producing at least one solid-state layer (1), at least comprising the steps:
providing a carrier substrate (2) having a first exposed surface (4) and having a second exposed surface (6),
producing a release layer (8) in the carrier substrate (2) or on the first exposed surface (4) of the carrier substrate (2), wherein the release layer (8) has an exposed surface (10),
producing a first solid-state layer (1) on the exposed surface (10) of the release layer (8), wherein the first solid-state layer (1) has a free surface (12) at a distance from the release layer (8),
arranging or forming a receiving layer (14) on the second exposed surface (6) of the carrier substrate (2) or on the free surface (12) of the first solid-state layer (1),
producing stresses within the release layer (8),
wherein the stresses are produced by tempering at least the receiving layer (14),
wherein a crack spreads within the release layer (8) or in the boundary region (16) between the release layer (8) and the solid-state layer (1) as a result of the stresses, wherein the first solid-state layer (1) is split off from the previously produced multi-layer arrangement by the crack,
**characterized in that**
the release layer (8) is produced as an amorphous layer on or in the carrier substrate (2).

2. Method according to Claim 1,
**characterized in that**
the release layer (8) is configured in such a way that it differs significantly in at least one mechanical property, in particular breaking strength, from the same mechanical property of a further layer, in particular from the first solid-state layer (1).

3. Method according to Claim 1 or 2,
**characterized in that**
the release layer (8) is produced, in particular grown, such on or in the carrier substrate (2), that the breaking strength of the release layer (8) is lower than the breaking strength of the first solid-state layer (1).

4. Method according to Claim 1 or 2,
**characterized in that**
the release layer (8) is grown on the carrier substrate (1) and is provided with a doping,
wherein, by means of the doping, the breaking strength of the release layer (8) is adjusted in such a way that it is lower than the breaking strength of the first solid-state layer (1), or querying the release layer (8) is produced by the conversion of an amorphous layer previously produced on or in the carrier substrate (2) into a crystalline layer,
wherein the carrier substrate (2) is present in a crystalline state and, as a result of the conversion of the amorphous layer into the crystalline release layer (8), the crystal lattice information of the crystal lattice of the carrier substrate (2) is transferred to the release layer (8) .

5. Method according to Claim 4,
**characterized in that**
the release layer (8) and the solid-state layer (1) are each at least partly produced by growth and, in particular, the first solid-state layer (1) preferably consists of gallium nitrite (GaN).

6. Method according to Claim 1,
**characterized in that**
the solid-state layer (1) comprises a base layer portion (30) and a main layer portion (32), wherein the base layer portion (30) is produced on the amorphous release layer (8) and the main layer portion (32) is produced on the base layer portion (30).

7. Method according to at least one of the preceding claims,
**characterized in that**
the crack spreads in a parting plane (18) within the release layer (8),
wherein the parting plane (18) extends parallel to the second exposed surface (6) of the carrier substrate (2) and parallel to the surface of the first solid-state layer (1) that is arranged on the release layer (8),
wherein the parting plane (18) is located in a region in the release layer (8) which is further from the carrier substrate (2) than from the first solid-state layer (1).

8. Method according to at least one of the preceding claims,
**characterized in that**
the stresses are produced by cooling at least the receiving layer (14), which preferably consists of a polymer material, in particular of PDMS, to a temperature of less than 10°C, in particular of less than 0°C and particularly preferably of less than -100°C.

9. Method according to at least one of the preceding claims,
**characterized in that**
a further receiving layer (20) is provided, wherein the receiving layer (14) is formed on the second exposed surface (6) of the carrier substrate (2), and wherein the further receiving layer (20) is arranged on the free surface (12) of the solid-state layer (1).

10. Method according to at least one of the preceding claims,
**characterized in that**
at least one further solid-state layer (100) is produced or arranged on the multilayer arrangement before the first solid-state layer (1) is split off, wherein the further solid-state layer (100) is split off together with the first solid-state layer (1).

11. Method according to at least one of the preceding claims,
**characterized in that**
a further carrier substrate (50) is produced or arranged on the solid-state layer (1) or on a further solid-state layer (100), in particular bonded on, wherein the first solid-state layer (1) and/or the further solid-state layer (100) forms a multi-layer arrangement with the further carrier substrate (50), in particular a glass or silicon layer, following the splitting.

12. Method according to one of the aforementioned claims,
**characterised in that**
the thickness of the release layer (8) is less than 1 µm, preferably than 100 nm and particularly preferably less than 10 nm.

## Revendications

1. Procédé de production d'au moins une couche (1) de semi-conducteur, comprenant au moins les stades :
on se procure un substrat (2) porteur, ayant une première surface (4) exposée et une deuxième surface (6) exposée ;
on produit une couche (8) de détachement dans le substrat (2) porteur ou sur la première surface (4) exposée du substrat (2) porteur, la couche (8) de détachement ayant une surface (10) à découvert ;
on produit une première couche (1) semi-conductrice sur la surface (10) à découvert de la couche (8) de détachement, la première couche (1) semi-conductrice ayant une surface (12) libre à distance de la couche (8) de détachement ;
on met ou on constitue une couche (14) de réception sur la deuxième surface (6) exposée du substrat (2) porteur ou sur la surface (12) libre de la première couche (1) semi-conductrice ;
on produit des contraintes au sein de la couche (8) de détachement,
les contraintes étant produites par une mise en température d'au moins la couche (14) de réception,
dans lequel il se propage, au sein de la couche (8) de détachement ou dans la région (16) limite entre la couche (8) de détachement et la couche (1) semi-conductrice, en raison des contraintes, une fissure, dans lequel, par la fissure, on sépare la couche (1) semi-conductrice de l'agencement stratifié produit auparavant,
**caractérisé en ce que**
on produit la couche (8) de détachement sur ou dans le substrat (2) porteur, sous la forme d'une couche amorphe.

2. Procédé suivant la revendication 1,
**caractérisé en ce que**
l'on configure la couche (8) de détachement de manière à ce qu'elle ait au moins une propriété mécanique, notamment la résistance à la rupture, significativement différente de la même propriété mécanique d'une autre couche, notamment de la première couche (1) semi-conductrice.

3. Procédé suivant la revendication 1 ou 2,
**caractérisé en ce que**
l'on produit la couche (8) de détachement sur ou dans le substrat (2) porteur, notamment en la faisant croître, de manière à ce que la résistance à la rupture de la couche (8) de détachement soit plus petite que la résistance à la rupture de la première couche (1) semi-conductrice.

4. Procédé suivant la revendication 1 ou 2,
**caractérisé en ce que**
l'on fait croître la couche (8) de détachement sur le substrat (1) porteur ou on la munit d'un dopage,
dans lequel, au moyen du dopage, on règle la résistance à la rupture de la couche (8) de détachement, de manière à ce qu'elle soit plus petite que la résistance à la rupture de la première couche (1) semi-conductrice ou dans lequel on produit la couche (8) de détachement par transformation d'une couche amorphe, produite auparavant sur ou dans le substrat (2) porteur, en une couche cristalline,
dans lequel le substrat (2) porteur se présente à l'état cristallin et, par la transformation de la couche amorphe en la couche (8) de détachement cristalline, on transfert l'information de réseau cristallin du réseau cristallin du substrat (2) porteur à la couche (8) de détachement.

5. Procédé suivant la revendication 4,
**caractérisé en ce que**
l'on produit la couche (8) de détachement et la couche (1) semi-conductrice, au moins en partie, respectivement, par croissante et notamment la première couche (1) semi-conductrice est de préférence en nitrure de gallium (GaN).

6. Procédé suivant la revendication 1,
**caractérisé en ce que**
la couche (1) semi-conductrice est constituée d'une partie (30) de couche de base et d'une partie (32) de couche principale, la partie (30) de couche de base étant produite sur la couche (8) de détachement amorphe et la partie (32) de couche principale sur la partie (30) de couche de base.

7. Procédé suivant au moins l'une des revendications précédentes,
**caractérisé en ce que**
la fissure se propage dans un plan (18) de séparation au sein de la couche (8) de détachement,
le plan (18) de détachement s'étendant parallèlement à la deuxième surface (6) exposée du substrat (2) porteur et parallèlement à la surface, disposée sur la couche (8) de détachement, de la première couche (1) semi-conductrice,
le plan (18) de séparation se trouvant dans une région de la couche (8) de détachement, qui est à une distance plus grande du substrat (2) porteur que de la première couche (1) semi-conductrice.

8. Procédé suivant au moins l'une des revendications précédentes,
**caractérisé en ce que**
l'on produit les contraintes par un refroidissement d'au moins la couche (14) de réception, qui est de préférence en un matériau polymère, notamment en PDMS, à une température de moins de 10°C, notamment de moins de 0°C et d'une manière particulièrement préférée de moins de - 100°C.

9. Procédé suivant au moins l'une des revendications précédentes,
**caractérisé en ce que**
l'on prévoit une autre couche (20) de réception, la couche (14) de réception étant constituée à la deuxième surface (6) exposée du substrat (2) porteur et l'autre couche (20) de réception étant disposée sur la surface (12) libre de la couche (1) semi-conductrice.

10. Procédé suivant au moins l'une des revendications précédentes,
**caractérisé en ce que**
l'on produit ou l'on met au moins une autre couche (100) semi-conductrice avant la séparation de la première couche (1) semi-conductrice de l'agencement stratifié, l'autre couche (100) semi-conductrice étant séparée ensemble avec la première couche (1) semi-conductrice.

11. Procédé suivant au moins l'une des revendications précédentes,
**caractérisé en ce que**
on produit ou on met, notamment par liaison, un autre substrat (50) porteur sur la couche (1) semi-conductrice ou sur une autre couche (100) semi-conductrice, la première couche (1) semi-conductrice et/ou l'autre couche (100) semi-conductrice constituant, après la séparation, avec l'autre substrat (50) porteur, notamment une couche de verre ou de silicium, un agencement stratifié.

12. Procédé suivant l'une des revendications précédentes,
**caractérisé en ce que**
l'épaisseur de la couche (8) de détachement est plus petite que 1 µm, de préférence plus petite que 100nm et, d'une manière particulièrement préférée, plus petite que 10nm.
